# EUROPEAN PATENT APPLICATION

(11) **EP 4 746 035 A1**
(43) Date of publication of application: **20.05.2026**
(21) Application number: 24213352.8
(22) Date of filing: 15.11.2024
(51) Int. Cl.: H01L 21/78, H01L 21/308, G03F 1/20

(54) **METHOD OF DICING A SEMICONDUCTOR WAFER**

(71) Applicant: Microsoft Technology Licensing, LLC, Redmond, WA 98052-6399 (US)
(72) Inventor: VIAZMITINOV, Dmitrii, Redmond, 98052-6399 (US)
(74) Representative: Page White Farrer

(57) **Abstract**

A method of dicing a semiconductor wafer comprises steps of a) positioning a stencil mask over the semiconductor wafer, with the stencil mask being spaced from the semiconductor wafer by a gap such that the stencil mask does not touch a component arranged on the semiconductor wafer, the stencil mask having an aperture; and b) subsequently etching through the semiconductor wafer by performing a reactive ion etch, wherein the stencil mask controls the etch. The method may allow a wafer to be diced without the use of die attach tape and without need for a cleaning step, and may be useful for dicing wafers bearing microelectromechanical systems. Also provided are a stencil mask and system useful in the method.

## Description

### Background

Semiconductor devices are fabricated on wafers. A wafer is a slice of single crystalline semiconductor material. The wafer may be significantly larger than an individual device. For example, silicon wafers with diameters of 300 mm are widely used in industrial fabrication processes, and the use of even larger wafers has been proposed.

In many fabrication processes, a plurality of devices is prepared in parallel on a shared wafer before dividing the wafer up into a plurality of dies, each die bearing one of the devices. The process of dividing a wafer into dies is referred to as wafer dicing or die singulation.

Various methods of wafer dicing are used in the art. Typically, the wafer is attached to an adhesive backing tape, referred to as a die attach tape or die bonding tape, before being cut using a dicing saw or a laser. The die attach tape leaves behind an adhesive residue on the bottom surface of the dies.

Cutting a wafer using a dicing saw or a laser generates particulate debris, which must be cleaned from the resulting dies. The cleaning process comprises spraying the cut die with water droplets and high-pressure air. Certain types of components, such as microelectromechanical systems ("MEMS"), can be damaged by the cleaning process.

Stealth dicing is a variant of laser dicing which is said to avoid the need for a cleaning step. In stealth dicing, a laser is focussed on a region inside the wafer thereby weakening the semiconductor material in that area. A tape expander is then used to stretch the die bonding tape holding the wafer, thereby pulling the wafer apart.

### Summary

In one aspect, there is provided a method of dicing a semiconductor wafer. The method comprises steps of: a) positioning a stencil mask over the semiconductor wafer, with the stencil mask being spaced from the semiconductor wafer by a gap such that the stencil mask does not touch a component arranged on the semiconductor wafer, the stencil mask having an aperture; and b) subsequently etching through the semiconductor wafer by performing a reactive ion etch, wherein the stencil mask controls the etch. The use of a reactive ion etch controlled by a stencil mask may allow the wafer to be etched without generating particulates, thereby avoiding the need for a cleaning step. In addition, no lithographic mask is needed to perform the dicing. The method may be compatible with wafers bearing delicate components such as microelectromechanical systems.

Another aspect provides a stencil mask for controlling a reactive ion etch. The stencil mask comprises a sheet of semiconductor material having a recess and an edge margin arranged around the recess; an aperture arranged in the recess; and a layer of an etch stop material covering the sheet of semiconductor material. The stencil mask is useful in the method.

Still another aspect provides a system comprising the stencil mask as defined above, and a carrier for supporting a semiconductor wafer to be diced.

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter. Nor is the claimed subject matter limited to implementations that solve any or all of the disadvantages noted herein.

### Brief Description of the Drawings

To assist understanding of embodiments of the present disclosure and to show how such embodiments may be put into effect, reference is made, by way of example only, to the accompanying drawings in which:
Fig. 1 is a flow diagram outlining an example method of dicing a semiconductor wafer;
Fig. 2 is a plan view of an example semiconductor wafer;
Fig. 3 is a cross-section of an example carrier useful in the method;
Fig. 4A is a plan view of an example stencil mask;
Fig. 4B is a cross-section of the stencil mask of Fig. 4A along line B...B;
Fig. 4C is a partial plan view of the stencil mask of Fig. 4A, showing a detailed view of an alignment window;
Fig. 5 is a flow diagram outlining an example method of etching a semiconductor wafer; and
Fig. 6 illustrates the use of a stencil mask to control etching of a semiconductor wafer.

The drawings are schematic and are not to scale. Relative proportions of certain elements may be exaggerated for clarity of representation.

### Detailed Description

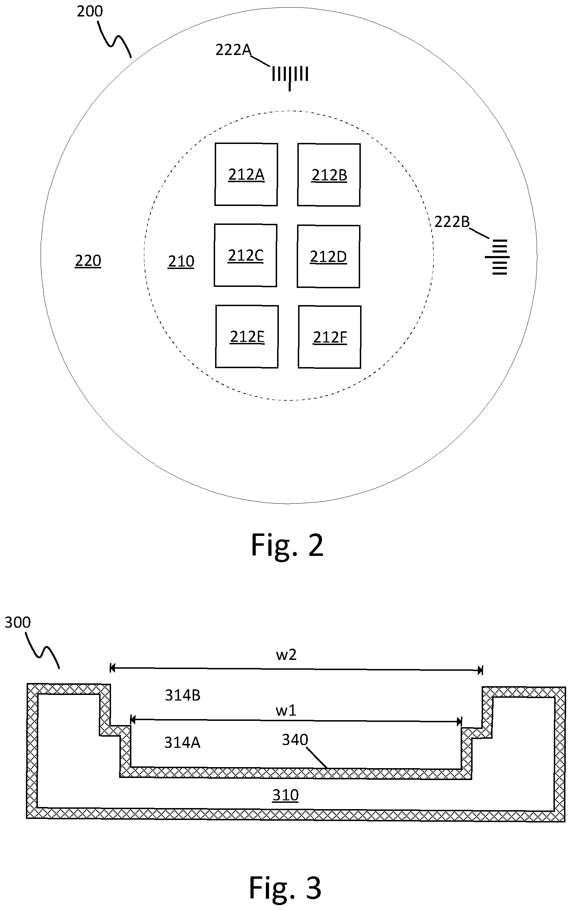

Directional terms such as "top", "bottom", "left", "right", "above", "below", "horizontal" and "vertical" are used herein for convenience of description and relate to the orientation shown in the drawings. For instance, the "top" of semiconductor wafer 200 of Fig. 2 is the surface which bears the components 212. For the avoidance of any doubt, directional terms are not intended to limit orientation in an external frame of reference.

In the present context, the terms "die" and "chip" are synonymous and may be used interchangeably.

"RIE" stands for reactive ion etching. "DRIE" stands for deep reactive ion etching. "MEMS" stands for microelectromechanical system.

Many existing dicing techniques require the use of die attach tape and/or a cleaning step and/or a lithographic mask formed directly on the surface of the wafer. Cleaning may cause physical damage to delicate components. Die attach tape leaves behind an organic reside on a back surface of the wafer, rendering the die unsuitable for further processing in ultra-high-vacuum ("UHV") environments. The existing techniques are therefore unsuitable for processing certain advanced devices, such as MEMS.

Provided herein are methods of dicing a semiconductor wafer which do not require the use of die attach tape or a lithographic mask, and which may avoid generating particulate debris. The methods may be particularly suitable for dicing semiconductor wafers bearing components that are vulnerable to physical damage, such as MEMS.

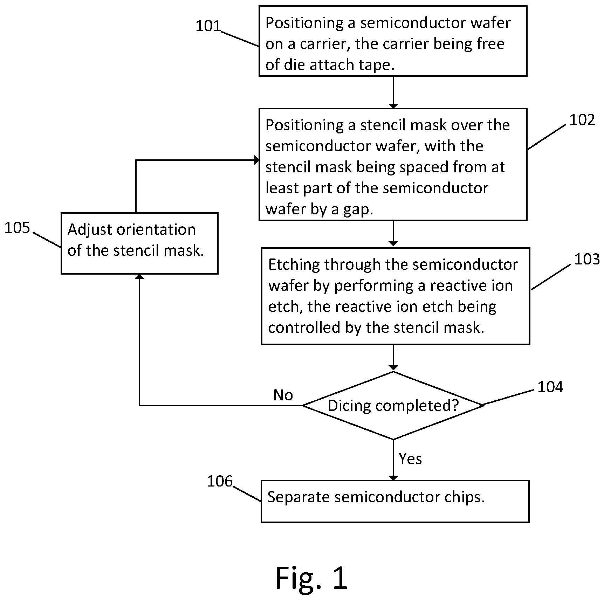

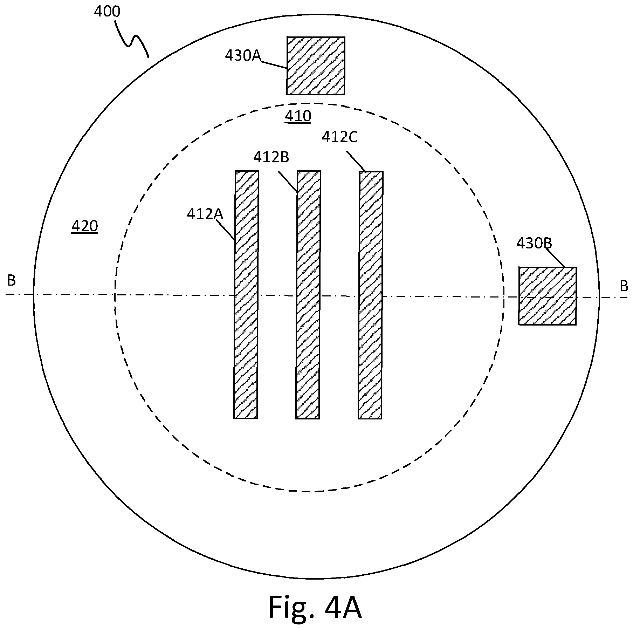

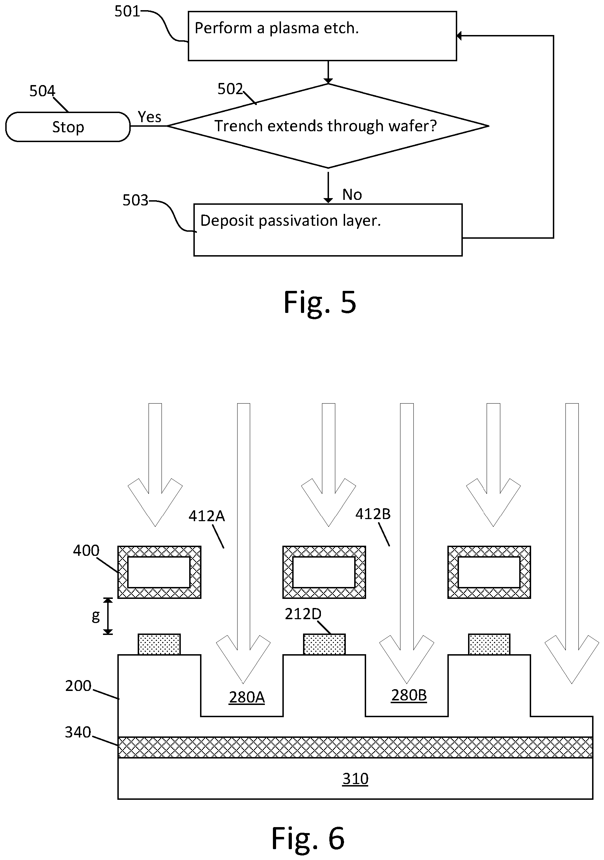

An example method of dicing a semiconductor wafer will now be explained with reference to the drawings. Fig. 1 is a flow diagram outlining the method. An example semiconductor wafer to be diced is shown in Fig. 2. Figs. 3 and 4A to 4C illustrate components useful for implementing the method. Figs. 5 and 6 provide details of etching techniques useful in the method.

The example method comprises positioning a semiconductor wafer on a carrier at block 101; positioning a stencil mask over the semiconductor wafer at block 102; and etching through the semiconductor wafer by reactive ion etching at block 103. If the dicing is not completed, then the orientation of the stencil mask may be changed at block 105, and a further etching operation may be performed. Once dicing is completed, the resultant individual semiconductor chips are separated at block 106. The various operations of the method are explained in more detail below.

At block 101 of Fig. 1, a semiconductor wafer to be diced is positioned on a carrier. The carrier is free of die attach tape.

A plan view of an example semiconductor wafer 200 is shown in Fig. 2. The wafer 200 comprises a planar slice of single-crystalline semiconductor material.

The illustrated wafer 200 is circular in plan. However, the shape and dimensions of the wafer are not particularly limited and may be selected as appropriate. By way of illustration, the wafer may have a thickness in the range 100 µm to 1 mm, and a diameter in the range 25 mm to 675 mm. In the case of non-circular wafers, the "diameter" is defined as the diameter of the smallest circle that would fully enclose wafer.

The wafer 200 includes a central region 210. The central region 210 comprises a plurality of components 212A to 212F which have been fabricated on the wafer. The components are spaced apart from one another. Each component may comprise a microelectromechanical system, or other sensitive component. Dicing is a process of dividing the wafer into a plurality of separate dies, each bearing a respective one of the components 212A to 212F.

The edge of the wafer 200 may be susceptible to damage, because the wafer may be physically handled by its edge. The components 212A to 212F are typically spaced from the edge of the wafer 200 by a margin 220. The margin 220 is typically free of fabricated components. In the illustrated example, the margin 220 includes alignment markers 222A, 222B in the form of scales etched into the margin region.

The nature of the semiconductor material used to form the wafer 200 is not particularly limited provided that the material can be etched using reactive ion etching, for example deep reactive ion etching.

The wafer 200 may, for example, comprise silicon. Silicon is a very widely used semiconductor material. Well-characterised methods of etching silicon are available in the art. When the wafer 200 comprises silicon, the reactive ion etch is typically a deep reactive ion etch.

Alternatively, the wafer 200 may comprise a III-V semiconductor. Examples of III-V semiconductors include indium phosphide, gallium arsenide, indium antimonide, and indium arsenide.

In accordance with still another possibility, the wafer 200 may comprise a II-VI semiconductor. Examples of II-VI semiconductors include cadmium telluride, mercury telluride, lead telluride and tin telluride.

At block 101 of the present method, the semiconductor wafer is positioned on a carrier. The carrier provides physical support for the semiconductor wafer, and may facilitate alignment of the semiconductor wafer with the stencil mask at subsequent block 102.

The nature of the carrier is not particularly limited, provided that the carrier is suitable for use in an apparatus for reactive ion etching such as an inductively-coupled plasma ("ICP") reactive ion etching apparatus. However, the carrier is most typically free of die attach tape. Die attach tape may also be referred to as dicing tape. A die attach tape comprises a polymer film bearing an adhesive. The use of die attach tape is undesirable because adhesive residue is unavoidably transferred from the die attach tape to the wafer. Wafers contaminated with adhesive residue are incompatible with further processing under ultra-high-vacuum ("UHV"; a pressure of less than or equal to 10⁻⁶ Pa) conditions. The presence of die attach tape may nevertheless be tolerated in some implementations, e.g. where processing under a UHV will not be performed.

Optionally, the carrier may comprise silicon coated with a layer of an etch stop material, such as aluminium oxide Al₂O₃. Silicon has good thermal conductivity and, when protected by an etch stop material, is compatible with ICP reactive ion etching.

An example of a suitable carrier 300 is illustrated in cross-section in Fig. 3.

The carrier 300 is formed from a wafer of semiconductor material 310, such as a wafer of silicon. The semiconductor material 310 is coated with a layer of etch stop material 340 which protects the carrier 300 from damage during the etching operations performed at block 103 of Fig. 1. The etch stop material may be selected as appropriate depending upon the etchant to be used. For example, when the etch comprises the Bosch process, the etch stop material may be aluminium oxide, Al₂O₃.

A recess extends into the carrier 300. The recess comprises a lower portion 314A having a first width w1, and an upper portion 314B having a second width w2. In the present example, the upper portion 314B of the recess is wider than the lower portion 314A. In other words, the recess has a stepped profile.

The lower portion 314A of the recess is configured to receive the semiconductor wafer 200 to be diced. The upper portion 314B is configured to receive a stencil mask, such as stencil mask 400 of Figs. 4A to 4C.

Block 101 of Fig. 1 may comprise, for example, press-fitting semiconductor wafer 200 into lower portion 314A of carrier 300.

After positioning the semiconductor wafer on the carrier, a stencil mask 400 is positioned over the semiconductor wafer 200 at block 102 of Fig. 1.

To avoid damaging the components 212A...212F on the semiconductor wafer 220, the stencil mask is positioned such that the stencil mask is spaced from the components 212A...212F by a gap. In other words, the stencil mask does not touch any component 212 on the semiconductor wafer 220. The stencil mask may touch the margin 220 of the semiconductor wafer 200.

The size of the gap is not particularly limited provided that the stencil mask does not touch the components 212A...212F and the stencil mask is close enough to the semiconductor wafer 200 to control the etching operation 103. The gap may for example have a size in the range 1 to 100 µm, optionally 50 to 100 µm.

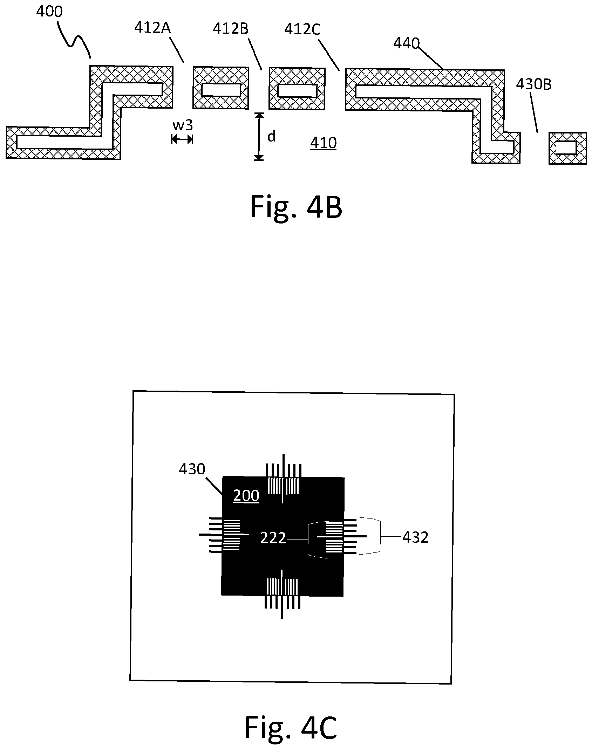

An example stencil mask 400 is illustrated in Figs. 4A, 4B, and 4C.

Fig. 4A is a plan view of stencil mask 400, and Fig. 4B is a cross-section of the stencil mask along line B...B of Fig. 4A.

The stencil mask 400 of this example is formed from a wafer of semiconductor material coated with a layer of etch stop material 440. The layer of etch stop material 440 may be as previously described with reference to the layer of etch stop material 340 of carrier 300. The layer of etch stop material 440 serves to protect the stencil mask from damage during etching operation 103.

The stencil mask 400 includes a recessed portion 410 surrounded by a margin 420. The recessed portion 410 may have a depth d in the range 1 to 100 µm, optionally 50 to 100 µm. The recessed portion 410 is configured such that, when the stencil mask 400 is placed over the semiconductor wafer 200 to be diced, the stencil mask does not touch the components 212A...212F in the central region 210 of the wafer 200. In this configuration, margin 420 of the stencil mask may rest on margin 210 of the semiconductor wafer 200.

A plurality of apertures 412A, 412B, 412C extend through the recessed portion 410. In use at block 103, a plasma etchant passes through the apertures 412A...421C thereby etching away portions of the semiconductor wafer 200 which are aligned with the apertures 412A...421C. The remainder of the plasma etchant is blocked by the stencil mask 400. The stencil mask 400 is thus configured to control a reactive ion etching process.

In the example, the apertures 412A...C are depicted as linear apertures. Each aperture may, for example, have a width w3 in the range 10 to 200 µm. Providing narrow apertures may improve the precision of the reactive ion etch. Wider apertures may in principle be used if desired. Since the stencil mask 400 of this example is formed from a semiconductor material, processing techniques such as lithography may be used to form apertures having precisely defined geometries, and a high degree of control over the size and shape of the apertures is possible.

Margin 420 of stencil mask 400 includes two alignment windows 430A, 430B. A sectional plan view of stencil mask 400 showing details of an alignment window is provided as Fig. 4C.

An alignment window 430 comprises an aperture extending through the stencil mask 400. An alignment marker 432 is provided at an edge of the alignment window 430. For example, alignment marker432 may be etched into the stencil mask 400. Alignment marker432 of this example is a scale.

In use, alignment marker 432 is aligned with a corresponding alignment marker 222 provided on the semiconductor wafer 200. This may allow for accurate positioning of the stencil mask 400 relative to the semiconductor wafer 200. Providing a plurality of alignment markers per alignment window, e.g., an alignment marker at each edge of alignment window 430, and/or a plurality of alignment windows may further facilitate accurate positioning of the stencil mask.

In the present example, alignment marker 222 on the semiconductor wafer 200 and alignment marker 432 of the stencil mask 400 are both scales, and together serve as a Vernier scale. A Vernier scale may provide better resolution than e.g. simple line marks.

Block 102 of Fig. 1 may comprise press-fitting stencil mask 400 into upper portion 314B of carrier 300, over the semiconductor wafer 200 such that the apertures 412 through the stencil mask 400 are aligned with spaces between the components 212 on the semiconductor wafer. The stepped shape of the recess 314A, 314B in the carrier 300 may be used to assist with accurate positioning of the stencil mask 400 relative to the semiconductor wafer 200.

After positioning the stencil mask 400 over the semiconductor wafer 200, the method of Fig. 1 proceeds to block 103 in which a reactive ion etch is performed to etch through the semiconductor wafer.

The conditions used for the reactive ion etch may be selected as appropriate based on the nature of the semiconductor material to be etched. The reactive ion etch may comprise a deep reactive ion etch.

An example of deep reactive ion etching process is outlined in the flow diagram of Fig. 5.

The illustrated process is an iterative process, which etches through the semiconductor wafer in a plurality of incremental steps. The process comprises repeated cycles of plasma etching at block 501, followed by deposition of a passivating layer at block 503.

A plasma etching operation 501 is illustrated in Fig. 6.

Stencil mask 400 is arranged over semiconductor wafer 200 such the stencil mask 400 is spaced from the semiconductor wafer by a gap g. The stencil mask 400 does not touch components 212D arranged on the top surface of the semiconductor wafer 200. The semiconductor wafer is supported on a carrier 310, 340.

Plasma ions are directed towards the semiconductor wafer 200 through apertures 412A, 412B of stencil mask 400. The portions of the semiconductor wafer that are exposed to the plasma ions are removed, thereby forming trenches 280A, 280B. The etch is performed for a short time interval, of the order of seconds.

Then, at block 503, a passivating material is deposited to protect the side-walls of the trenches 280A, 280B from the plasma.

Operations 501 and 503 are repeated until the trenches 280A, 280B extend all the way through the semiconductor wafer 200, at which point the etching terminates at block 404.

The nature of the plasma etchant and passivating material may be selected as appropriate depending upon the semiconductor material to be etched.

For example, when the semiconductor material is silicon, the etchant may comprise sulfur hexafluoride, and the passivation layer may comprise a polyfluoroalkane, e.g. poly(tetrafluoroethylene). The reactive ion etch may comprise the Bosch process.

Since the etch is controlled by the stencil mask, it is not necessary to form a lithographic mask on the surface of the semiconductor wafer 200. The method of dicing the semiconductor wafer 200 is typically free of the use of a lithographic mask on the wafer. The semiconductor wafer 200 may bear a lithographic mask used in the fabrication of component(s) on the semiconductor wafer 200, provided that the lithographic mask is not used to control the dicing. In some implementations, the semiconductor wafer 200 may be free of any lithographic mask.

The etching may divide the semiconductor wafer into a plurality of dies or chips. The method of Fig. 1 may then proceed to step 106, in which the individual dies or chips are separated. For example, the stencil mask may be moved away from the carrier, and a vacuum tweezer may be used to pick up the individual dies or chips. Any other appropriate technique for isolating individual ones of the dies or chips may be used.

It is contemplated that the method of Fig. 1 may comprise two or more etching operations 103.

A single etching operation 103 may divide a wafer into elongate strips if the stencil mask is sized such that the apertures in the mask have a length greater than or equal to the diameter of the wafer.

More typically, two etching operations 103 may be performed to form cuts at different locations on the wafer. In the method illustrated in Fig. 1, the orientation of the stencil mask relative to the semiconductor wafer is adjusted at block 105, such that each etching operation 103 forms trenches at respective different locations on the semiconductor wafer. Changing the orientation of the stencil mask comprises rotating the stencil mask.

In the present example, the components 212A...212F are arranged in a rectilinear grid and are to be diced into rectangular chips. Dicing the wafer may therefore comprise forming a first cut using a stencil mask having apertures aligned with the vertical axis of the grid; rotating the stencil mask by 90° relative to the wafer to align the stencil mask with the horizontal axis of the grid; and then forming a second cut. More generally, when positions of the cuts to be made in the wafer have rotational symmetry, the cuts may be made using a single stencil mask.

Alternatively, a respective different stencil mask may be used for each etching operation 103. Multiple stencil masks are used in implementations where the positions or shapes of the cuts to be made through the wafer lack rotational symmetry. In such implementations, block 105 instead comprises replacing the stencil mask with a different stencil mask.

Various modifications may be made to the described method. #

The use of carrier 300 having a recess is optional. The semiconductor wafer may be positioned on any suitable support, for example a planar surface. The stencil mask and the semiconductor wafer may be held together using, for example, a polyimide tape such as a Kapton (RTM) tape placed around outer edge of the semiconductor wafer and the stencil mask. "Kapton" may refer to co-polymers obtainable by the polymerisation of pyromellitic dianhydride ("PMDA"), 4,4'-oxydiphenlamine ("ODA"), and optionally one or more of biphenyltetracarboxylic acid dianhydride ("BPDA") and p-phenylenediamine ("PPD").

The carrier 300 and stencil mask 400 of the Examples are fabricated from semiconductor materials, which may allow for the use of high-precision manufacturing techniques, such as lithography. The materials of the carrier and stencil mask are however not particularly limited and may be selected as appropriate.

The illustrated stencil mask comprises linear apertures. Linear apertures may be useful if the semiconductor wafer is to be diced into square or rectangular chips. However, there is no particular limitation on the configuration of the apertures, and other shapes may be used.

The number of alignment windows and the number of alignment markers may be selected as appropriate. In some implementations, alignment windows and alignment markers may be omitted. When alignment markers are omitted from the stencil mask, alignment marker(s) on the semiconductor wafer are typically also omitted.

The alignment markers in the illustrated example provide Vernier scales. In variants, alternative alignment markers may be used instead of or in addition to Vernier scales.

The illustrated wafer and stencil mask are each illustrated as being circular in plan. The shapes of the wafer and stencil mask are however not particularly limited and may be selected as desired. It is contemplated that using a stencil mask having a perimeter with a finite degree of rotational symmetry (e.g., a rectangular, optionally square, shape) may allow for easier alignment of the stencil mask with the wafer.

In the example, the stencil mask 400 includes a recessed portion 410. In a variant, the recessed portion may be omitted and the carrier may be configured to hold the semiconductor wafer and stencil mask with a gap therebetween.

Performing an iterative etching process as in Fig. 5 is not necessarily essential. More generally, block 103 comprises performing a reactive ion etch controlled by a stencil mask.

It will be appreciated that the above embodiments have been described by way of example only.

More generally, according to one aspect disclosed herein, there is provided a method of dicing a semiconductor wafer. The method comprises steps of: a) positioning a stencil mask over the semiconductor wafer, with the stencil mask being spaced from at least part of the semiconductor wafer by a gap, the stencil mask having an aperture; and b) subsequently etching through the semiconductor wafer by performing a reactive ion etch, wherein the stencil mask controls the etch. Dicing the wafer using reactive ion etching may avoid generating particulates.

The method may be performed in the absence of any die attach tape. This may avoid leaving organic residues on the wafer, allowing for further processing of the wafer in an ultra-high vacuum environment.

The method may comprise performing at least two iterations of steps a) and b). For each iteration of step a), the stencil mask may be positioned in a different orientation with respect to the semiconductor wafer. This may allow a single stencil mask to be used to form cuts through the wafer at multiple positions, and is useful where the positions of the cuts have rotational symmetry. Alternatively, a different stencil mask for each iteration of step a). Repositioning the stencil mask or using different stencil masks allows the wafer to be cut at different positions.

The method may comprise steps of:
a1) positioning a first stencil mask over the semiconductor wafer in a first orientation, with the first stencil mask being spaced from the semiconductor wafer by a gap;
b1) subsequently etching through the semiconductor wafer by performing a first reactive ion etch, wherein the first stencil mask controls the first reactive ion etch;
a2) positioning the first stencil mask over the semiconductor wafer in a second orientation with the first stencil mask being spaced from the semiconductor wafer by a gap, wherein the first orientation and the second orientation are different; and
b2) subsequently etching through the semiconductor wafer by performing a second reactive ion etch, wherein the first stencil mask controls the second reactive ion etch.

Optionally, the stencil mask may be square or rectangular and step a2) may comprise rotating the stencil mask by 90°. Use of a square or rectangular stencil mask may allow for easier alignment of the stencil mask with the semiconductor wafer.

In a variant, step a2) may comprise removing the first stencil mask, and positioning a second stencil mask over the semiconductor wafer, the second stencil mask being spaced from the semiconductor wafer by a gap, wherein the first and stencil masks are different. In this variant, the second stencil mask controls the reactive ion etch performed at step b2).

Step b2) may divide the semiconductor wafer into a plurality of semiconductor chips. In implementations where the semiconductor wafer comprises a plurality of MEMS, each semiconductor chip of the plurality of semiconductor chips may bear a respective MEMS.

The size of the gap between the stencil mask and the wafer may, for example, be in the range 1 to 100 µm. Spacing the stencil mask from the wafer may avoid damage to sensitive components on the wafer. Arranging the stencil mask close to the wafer may allow for a high resolution etch.

The stencil mask may comprise a sheet of semiconductor material coated with a layer of an etch stop material. For example, the sheet of semiconductor material comprises a sheet of silicon, and wherein the etch stop material comprises aluminium oxide. Forming the stencil mask from a semiconductor material may allow a high degree of control over the shape of the apertures in the stencil mask, since techniques such as lithography may be used to form the stencil mask.

The aperture may have a width in the range 10 to 200 µm. This may allow for a high-resolution etch.

The aperture may be linear. A mask with a linear aperture may be conveniently used to dice a wafer into a plurality of rectangular chips.

The stencil mask may include a marking for aligning the stencil mask with the semiconductor wafer. For example, the stencil mask may further comprise an alignment window, the marking being arranged at an edge of the alignment window. The marking may comprise a first scale, and the semiconductor wafer may include a second scale arranged to be aligned with the first scale. The first and second scales may thus provide a Vernier scale.

The reactive ion etching may comprises deep reactive ion etching.

The semiconductor wafer may be a silicon wafer. In such implementations, the reactive ion etching may comprise Bosch deep reactive ion etching.

The method may further comprise, before step a), positioning the semiconductor wafer on a carrier, the carrier being free of adhesive and free of die attach film. The carrier may support the wafer during the method, and may allow for easier handling. The carrier may include a recess configured to receive the semiconductor wafer. For example, the wafer may be push-fit into the recess.

The recess may have a stepped profile comprising a lower portion configured to receive the semiconductor wafer, and an upper portion configured to receive the stencil mask, the upper portion being larger in plan than the lower portion. The wafer may be push-fit into the lower portion, and the stencil mask may be push-fit into the upper portion. Providing such a recess may allow easier alignment of the stencil mask with the wafer.

Where it is said that the stencil mask being spaced from at least part of the semiconductor wafer by a gap, it is meant that the stencil mask does not touch a part of the semiconductor wafer that bears a component, such as an integrated circuit or a MEMS, that might be damaged by contact with the stencil mask. In some implementations, the stencil mask may touch a parts of the semiconductor wafer that does not bear any components, e.g. a margin region surrounding the components. In other implementations, the stencil mask does not touch the semiconductor wafer at all.

The method provided herein may be useful for dicing wafers bearing sensitive components. For example, the semiconductor wafer to be diced may bear one or more microelectromechanical systems.

Since the method uses a stencil mask, it is not necessary to form a lithographic mask on the wafer to be diced. The method may therefore be free of the use of a lithographic mask to control the dicing.

Another aspect provides a stencil mask for controlling a reactive ion etch. The stencil mask is useful in the method, and comprises a sheet of semiconductor material having a recess and an edge margin arranged around the recess; an aperture arranged in the recess; and a layer of an etch stop material covering the sheet of semiconductor material.

The various features of the stencil mask discussed with reference to the method may equally be implemented in the context of the mask aspect.

For instance, the aperture may have a width in the range 10 to 200 µm. Alternatively or additionally, the aperture may be linear. Alternatively or additionally, the stencil mask may be square. Alternatively or additionally, the stencil mask may further comprising an alignment window in the edge margin, and a marker arranged at an edge of the alignment window. When present, the marker may be a Vernier scale.

The sheet of semiconductor material may be a sheet of silicon, and the etch stop material comprises aluminium oxide. When protected by aluminium oxide, silicon has good compatibility with RIE systems, such as ICP-RIE systems.

Another related aspect provides a system comprising a stencil mask, and a carrier for supporting a semiconductor wafer and the stencil mask. The stencil mask may be as discussed above. The carrier may be as described with reference to the method aspect.

For example, the carrier may have a recess configured to receive the semiconductor wafer.

The recess may have a stepped profile, the stepped profile comprising a lower portion configured to receive the semiconductor wafer, and an upper portion configured to receive the stencil mask, the upper portion being larger than the lower portion in plan.

The carrier may comprise sheet of semiconductor material coated with an etch stop material. The semiconductor material may be silicon and the etch stop material may be aluminium oxide.

Other variants or use cases of the disclosed techniques may become apparent to the person skilled in the art once given the disclosure herein. The scope of the disclosure is not limited by the described embodiments but only by the accompanying claims.

## Claims

1. A method of dicing a semiconductor wafer, which method comprises steps of:
a) positioning a stencil mask over the semiconductor wafer, with the stencil mask being spaced from the semiconductor wafer by a gap such that the stencil mask does not touch a component arranged on the semiconductor wafer, the stencil mask having an aperture; and
b) subsequently etching through the semiconductor wafer by performing a reactive ion etch, wherein the stencil mask controls the etch.

2. The method according to claim 1, which is performed in the absence of any die attach tape.

3. The method according to claim 1 or claim 2, comprising performing at least two iterations of steps a) and b);
optionally wherein, for each iteration of step a), the stencil mask is positioned in a different orientation with respect to the semiconductor wafer.

4. The method according to claim 3, comprising steps of:
a1) positioning the stencil mask over the semiconductor wafer in a first orientation, with the stencil mask being spaced from the semiconductor wafer by a gap;
b1) subsequently etching through the semiconductor wafer by performing a first reactive ion etch, wherein the stencil mask controls the first reactive ion etch;
a2) positioning the stencil mask over the semiconductor wafer in a second orientation with the stencil mask being spaced from the semiconductor wafer by a gap, wherein the first orientation and the second orientation are different; and
b2) subsequently etching through the semiconductor wafer by performing a second reactive ion etch, wherein the stencil mask controls the second reactive ion etch.

5. The method according to claim 4, wherein:
the stencil mask is rectangular, optionally square, and step a2) comprises rotating the stencil mask by 90°; and/or
step b2) divides the semiconductor wafer into a plurality of semiconductor chips.

6. The method according to any preceding claim, wherein the gap has a size in the range 1 to 100 µm.

7. The method according to any preceding claim, wherein the stencil mask comprises a sheet of semiconductor material coated with a layer of an etch stop material;
optionally wherein the sheet of semiconductor material comprises a sheet of silicon, and wherein the etch stop material comprises aluminium oxide.

8. The method according to any preceding claim, wherein:
i) the aperture has a width in the range 10 to 200 µm; and/or
ii) the aperture is linear.

9. The method according to any preceding claim, wherein the stencil mask includes a marking for aligning the stencil mask with the semiconductor wafer; optionally wherein:
i) the stencil mask further comprises an alignment window, the marking being arranged at an edge of the alignment window; and/or
ii) the marking comprises a first scale, and wherein the semiconductor wafer includes a second scale arranged to be aligned with the first scale thereby forming a Vernier scale.

10. The method according to any preceding claim, wherein the reactive ion etching comprises deep reactive ion etching;
optionally wherein the semiconductor wafer is a silicon wafer, and the reactive ion etching comprises Bosch deep reactive ion etching.

11. The method according to any preceding claim, wherein the method further comprises, before step a), positioning the semiconductor wafer on a carrier, the carrier being free of adhesive and free of die attach film,
optionally wherein the carrier includes a recess configured to receive the semiconductor wafer;
further optionally wherein the recess has a stepped profile and comprises a lower portion configured to receive the semiconductor wafer, and an upper portion configured to receive the stencil mask, the upper portion being larger in plan than the lower portion.

12. The method according to any preceding claim, wherein the component comprises a microelectromechanical system.

13. A stencil mask for controlling a reactive ion etch, which stencil mask comprises:
a sheet of semiconductor material having a recess and an edge margin arranged around the recess;
an aperture arranged in the recess; and
a layer of an etch stop material covering the sheet of semiconductor material.

14. The stencil mask according to claim 13, wherein:
i) the aperture has a width in the range 10 to 200 µm; and/or
ii) the aperture is linear; and/or
iii) the stencil mask further comprises an alignment window in the edge margin, and a marker arranged at an edge of the alignment window, optionally wherein the marker comprises a scale; and/or
iv) the stencil mask is square or rectangular.

15. A system comprising a stencil mask as defined in claim 13 or claim 14 and a carrier for supporting a semiconductor wafer and the stencil mask;
optionally wherein the carrier has a recess configured to receive the semiconductor wafer;
further optionally wherein the recess has a stepped profile, the stepped profile comprising a lower portion configured to receive the semiconductor wafer, and an upper portion configured to receive the stencil mask, the upper portion being larger than the lower portion in plan.

## Amended claims

### Amended claims in accordance with Rule 137(2) EPC.

1. A method of dicing a semiconductor wafer (200) into a plurality of separate dies, which method comprises steps of:
a) positioning (102) a stencil mask (400) over the semiconductor wafer (200), with the stencil mask (400) being spaced from the semiconductor wafer (200) by a gap (g) such that the stencil mask (400) does not touch a component (212A) arranged on the semiconductor wafer (200), the stencil mask (400) having an aperture (412A); and
b) subsequently etching (103) through the semiconductor wafer (200) by performing a reactive ion etch, wherein the stencil mask (400) controls the etch.

2. The method according to claim 1, which is performed in the absence of any die attach tape.

3. The method according to claim 1 or claim 2, comprising performing at least two iterations of steps a) and b);
optionally wherein, for each iteration of step a), the stencil mask (400) is positioned in a different orientation with respect to the semiconductor wafer (200).

4. The method according to claim 3, comprising steps of:
a1) positioning the stencil mask (400) over the semiconductor wafer (200) in a first orientation, with the stencil mask (400) being spaced from the semiconductor wafer (200) by a gap (g);
b1) subsequently etching through the semiconductor wafer (200) by performing a first reactive ion etch, wherein the stencil mask (400) controls the first reactive ion etch;
a2) positioning the stencil mask (400) over the semiconductor wafer (200) in a second orientation with the stencil mask (400) being spaced from the semiconductor wafer by a gap (g), wherein the first orientation and the second orientation are different; and
b2) subsequently etching through the semiconductor wafer (200) by performing a second reactive ion etch, wherein the stencil mask (400) controls the second reactive ion etch.

5. The method according to claim 4, wherein:
the stencil mask (400) is rectangular, optionally square, and step a2) comprises rotating the stencil mask (400) by 90°; and/or
step b2) divides the semiconductor wafer (200) into the plurality of separate dies.

6. The method according to any preceding claim, wherein the gap (g) has a size in the range 1 to 100 µm.

7. The method according to any preceding claim, wherein the stencil mask (400) comprises a sheet of semiconductor material coated with a layer of an etch stop material (440).

8. The method according to claim 7, wherein the sheet of semiconductor material comprises a sheet of silicon, and wherein the etch stop material (440) comprises aluminium oxide.

9. The method according to any preceding claim, wherein:
i) the aperture (412A) has a width in the range 10 to 200 µm; and/or
ii) the aperture (412A) is linear.

10. The method according to any preceding claim, wherein the stencil mask includes a marking (432) for aligning the stencil mask (400) with the semiconductor wafer (200); optionally wherein:
i) the stencil mask (400) further comprises an alignment window (430), the marking (432) being arranged at an edge of the alignment window (430); and/or
ii) the marking (432) comprises a first scale, and wherein the semiconductor wafer (200) includes a second scale (222) arranged to be aligned with the first scale (432) thereby forming a Vernier scale.

11. The method according to any preceding claim, wherein the reactive ion etching comprises deep reactive ion etching;
optionally wherein the semiconductor wafer (200) is a silicon wafer, and the reactive ion etching comprises Bosch deep reactive ion etching.

12. The method according to any preceding claim, wherein the method further comprises, before step a), positioning the semiconductor wafer (200) on a carrier (300), the carrier (300) being free of adhesive and free of die attach film.

13. The method according to claim 12, wherein the carrier (300) includes a recess (314A, 314B) configured to receive the semiconductor wafer (200).

14. The method according to claim 13, wherein the recess (314A, 314B) has a stepped profile and comprises a lower portion (314A) configured to receive the semiconductor wafer (200), and an upper portion (314B) configured to receive the stencil mask (400), the upper portion (314B) being larger in plan than the lower portion (314A).

15. The method according to any preceding claim, wherein the component (212A) comprises a microelectromechanical system.
